# EUROPEAN PATENT SPECIFICATION

(11) **EP 3 139 180 B1**
(45) Date of publication and mention of the grant of the patent: **11.11.2020**
(21) Application number: 15184143.4
(22) Date of filing: 07.09.2015
(51) Int. Cl.: G01R 1/067, G01R 13/02

(54) **WIRELESS PROBE FOR MEASURING ELECTRICAL SIGNALS, OSCILLOSCOPE SYSTEM AND MEASURING METHOD USING SAID SYSTEM**
KABELLOSE SONDE ZUR MESSUNG ELEKTRISCHER SIGNALE, OSZILLOSKOPSYSTEM UND MESSVERFAHREN MIT DIESEM SYSTEM
SONDE SANS FIL POUR MESURES DE SIGNAUX ÉLECTRIQUES, SYSTÈME D'OSCILLOSCOPE ET PROCÉDÉ DE MESURE UTILISANT CE SYSTÈME

(43) Date of publication of application: 08.03.2017
(73) Proprietor: Ikalogic S.A.S., 87068 Limoges Cedex (FR)
(72) Inventor: KAMAL, Ibrahim Abdel-Aziz Mohamed, 87068 LIMOGES (FR); CANOZ, Victor Pierre, 87068 LIMOGES Cedex (FR); COTTENY, Frédéric, 87068 LIMOGES Cedex (FR)
(74) Representative: van Essen, Peter Augustinus

(56) References cited:
- EP-A1- 1 750 135
- WO-A1-2005/124370
- JP-B2- 3 396 106
- US-A1- 2009 212 938
- US-A1- 2009 267 590
- US-A1- 2012 154 172
- US-A1- 2013 006 570
- US-A1- 2014 191 748
- US-B1- 6 734 689

## Description

### Field of the invention

The invention relates to a probe for measuring an electrical signal at a measuring point in a circuit.

### Background of the invention

When developing or repairing electrical devices and circuits, often electrical signals and voltages need to be measured, and usually also visualised. To that end, oscilloscopes have been developed. These oscilloscopes comprise circuitry for measuring the electronic signals, and a display for representing these electrical signals in various way, for instance time-based. This circuitry may also be adapted for measuring and visualising digital signals, for instance based upon triggering signals.

Usually, these oscilloscopes comprise one or more measuring probes that are connected to the oscilloscope. The probe often comprises a simple conductive pin Oscilloscope probes often comprises a simple conductive pin associated to impedance matching components like resistors and capacitors, and having an insulation sheeting for allowing a user to manually operate the probe and place the conductive pin at measuring positions of a circuitry or device to be measured.

Developments were made to provide a user with more flexibility, by allowing removal of a lead connecting the probe with the oscilloscope. This, a probe was developed that could be wirelessly coupled to an oscilloscope. An example of such combination of probe and oscilloscope are for instance EP2693222 and CN103180745.

A further development was a probe that is adapted for controlling the oscilloscope. Examples are for instance provided in US2009212938A1 and GB2402223.

WO2005124370 relates to a handheld wireless probe for performing measurements like voltage, temperature, tyre pressure, or scanning a barcode.

US2013006570, US 2012154172 and JP3396106 relate to an oscilloscope having a measuring tip that is wirelessly connected to the oscilloscope.

US6734689 relates to an oscilloscope having a wire-connected measuring tip that pressure-activates the oscilloscope.

EP1750135 relates to an oscilloscope having a wire-connected tip.

US2014191748 relates to an oscilloscope having a wire-connected measuring tip

### Summary of the invention

The invention provides a probe that provides easy handling during measuring.

The invention pertains to a probe of claim 1.

The current probe intends to replace regular oscilloscope probes in situations where only one channel measurement is needed. The main idea is to remove the need for wires between the physical probe and display. This done by implementing a complete oscilloscope hardware within the probe (without all the display related hardware). Using the current probe, it is possible to measure an analogue voltage signal on its probe tip for a certain duration and stores the samples on an on-board memory. Data is then compressed and streamed to a display device via high speed Wifi connection. Alternatively, the signal is transmitted substantially life to an external device having a display, and a representation is shown in the display.

In an embodiment, in said capturing position said measuring tip provides an event for capturing and transmitting measurement data. The event may be one single capturing and transmission event, that initiates transferral of measurement data to the wireless communication device and that set the wireless transmission device to transmit the data. These actions and events may be managed and controlled by the data processor.

In an embodiment wherein said measuring tip is in its capturing position, captured measurement data is stored into a memory and transmitted via said wireless communication device. In particular, said captured measurement data is stored and transmitted while said measurement tip is in its capturing position. In this way, a user has easy control over the measurement and capturing of data.

In an embodiment, said wireless communication device is coupled to said data processor for transmitting measurement data to an external device comprising a display. This in particular makes the probe easy to use in daily work, but also relatively low cost. The displaying and possible processing of the measurement data can be done on for instance a tablet device, a smartphone, and the like.

In an embodiment, the user input device is functionally coupled to said data processor for providing a user input to said data processor. For instance, when said user input device is a wheel, touch surface, or the like, possibly in combination with a push button, a user can during use easily provide input that is transmitted to the display device. At the display device, feedback or a representation may be depicted, for instance a pick-list, event button, or another known graphical (or even audible) feedback or selection event. Via the user input device, a user can change settings, zoom in and out in a graph showing data, or any other action.

In an embodiment, the probe further comprises a user feedback device, functionally coupled to said data processor, for providing user feedback selected from measurement data, probe status, and probe setting information. The user feedback device on the probe provides a feedback signal to a user that can be perceived by the user. Such a feedback may be visible, audible, or for instance sensed via touch.

In an embodiment, said user feedback device comprises a lighting element in said housing, for providing visual feedback on an operational mode or measurement data.

In an embodiment, the probe further comprises a motion detection device in said probe that is operationally coupled to said data processor. In particular, said motion detection device is adapted for setting said data processor in a mode that sets the data processor ready for receiving measurement data and for controlling said wireless transmitted for transmitting said received measurement data when motion is detected. In particular furthermore said measurement tip is coupled to said data processor for in its capturing position activating said data processor in an active mode for receiving measurement data and controlling said wireless transmitted for transmitting said received measurement data while said measuring tip is in its capturing position.

In an embodiment, when the motion sensor detects motion of the probe, for instance picking it up, displacing the probe, and the like, the motion sensor activated further device in the probe to make then ready for receiving measurement data. This can save power usage of the probe, allowing to make it even more compact and thus easy to use.

In an embodiment, the measurement tip has an elongated shape. In particular, the measurement tip can be rod-shaped. It can be biased in its longitudinal direction, wherein said measurement tip is coupled to a switch that is functionally coupled to at least one selected from said communication device, said electrical signal processing circuit, and said data processor. The switch allows the measuring tip to generate an event.

In an embodiment, the probe further comprises a grounding attachment for attaching a grounding wire.

The invention further pertains to an oscilloscope system comprising the probe and an external computer device. The external computer device can for instance include at least one selected from a smartphone, tablet, a notebook. The external computer device comprising a display, a wireless communication device for communicating with said wireless communication device of said probe, and a data processor, functionally coupled with said display and said wireless communication device of the computer device.

In an embodiment, the computer device comprises software which, when running on said computer device, allows said computer device to receive data from said probe and to display a representation of said data on said display. In particular said software allows said computer device to receive user input via said user input device, display said user input on said display, and transmit data to said probe based upon said user input.

The oscilloscope allows usage of further available computer devices to provide a versatile, flexible and easy to use oscilloscope.

The invention further pertains to a method for measuring an electrical signal using the oscilloscope system, wherein said measurement tip is contacted with said measurement point, said housing is pressed down in a longitudinal direction of said measurement tip from said released position into said capturing position, electrical signal data is captured as measurement data, and said measurement data is transmitted to said computer device and displayed on said display.

In an embodiment, the measurement data is transmitted while said measurement tip is in said capturing position.

In an embodiment, user input on the user input device is transmitted via said wireless communication device to said (external) computer device and a representation of said user input is displayed on said display of said (external) computer device, and data is transmitted from said (external) computer device to said wireless communication device for amending probe settings. Such data can be user input, provided via said user input device. The user input triggers for instance a graphical representation on a display on said (external) computer device. On the display of the (external) computer device, a change in a setting of the probe may be indicated. Upon selection of such a change, the (external) computer device may transmit the changed setting to the probe, thus actually changing a setting of the probe.

The invention further pertains to a probe for measuring an electrical signal at a measuring point in a circuit, said probe comprising a housing provided at one end with a measuring tip, said housing further provided with a power supply, an electrical signal processing circuit, a data processor, a wireless communication device and a user input device, said electrical signal processing circuit, said wireless communication device and said manual control device functionally coupled to said data processor.

The invention further pertains to a computer program product which, when running a data processor, allows said data processor to wirelessly communicate with said probe described. The software running on said data processor allows displaying of a graphical user interface, allows receiving user input provided on said probe, allows process said user input into settings on said probe, and transmit said settings to said probe for implementation on said probe.

The probe is in particular designed to address two specific use cases:
- Office work: the probe can be functionally coupled to an office network. Furthermore, a display device can also be coupled to the same network. Communication between probe and display device can be done using the office network, for instance via a router.
- Field work : When no local network is present, in an embodiment the probe creates its own wireless LAN network to which a display device can connect. This created network can then be used for the probe to send data to a display device.

General features:
- Data capturing and measurement are carried by on board electronics
- The probe can be fully wireless. It can be powered from a battery, and send data to a remote display wirelessly, for instance via WIFI.
- As a display, a remote display on for instance a computer, a smartphone or a tablet (or any WIFI equiped device) can be used.
- The probe is enabled to build a network or be part of a network. For instance a WIFI network. That works in "Access-point" mode as well as "station" mode (for office/field work), for instance.

In an embodiment, the probe includes the following features:
- Interaction with the probe is done via a user interface, like a thumb wheel or a clickable thumb-wheel. This allows the user to adjust for instance the waveform measurement parameters (zoom level, vertical and horizontal offset, trigger level) using only for instance the thumb-wheel. This allows the user to hold the probe and make adjustments all with one hand, and without removing the probe tip from the test point.
- The probe is designed so that right handed and left handed users equally can use it.
- Status feedback is provided for instance via a multi-color LED that diffuses light to the probe tip. The probe tip is designed in a way that allows the status light to be visible from all angles. The status may be used to indicate the « trigger status » for example. Alternatively, such a status light may be provided at an end of the probe opposite to the measuring tip, and for instance direct its light away from the measuring tip. Thus, illumination of the measuring spot may be prevented.
- The probe tip can be mechanically connected to a push-button in such a way that a pressure on the probe tip can be detected by the probe. This can be very useful to implement an « automatic hold » function: Usually one needs to press the hold button to freeze a waveform on the display for further analysis. With the probe's tip, this can be fully automated: When a user releases the probe tip the last captured waveform is held on screen. This further increases the usability of the current probe with one hand only.
- An accelerometer is used to help the probe balancing its power consumption and it's reactivity. When turned on, a WIFI module needs few seconds (some times a dozen) before connecting to a network and be operational. With an accelerometer, the probe can wake-up the WIFI module as soon as the probe is grabbed, ensuring it's ready to capture samples and send them to a display when user needs.

The person skilled in the art will understand the term "substantially" in this application, such as in "substantially encloses" or in "substantially extends up to". The term "substantially" may also include embodiments with "entirely", "completely", "all", etc. Hence, in embodiments the adjective substantially may also be removed. Where applicable, the term "substantially" may also relate to 90% or higher, such as 95% or higher, especially 99% or higher, even more especially 99.5% or higher, including 100%. The term "comprise" includes also embodiments wherein the term "comprises" means "consists of'.

Furthermore, the terms first, second, third and the like if used in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

The probe herein are amongst others described during operation. As will be clear to the person skilled in the art, the invention is not limited to methods of operation or devices in operation.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "to comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer. In the device or apparatus claims enumerating several means, several of these means may be embodied by one and the same item of hardware. The mere fact that certain measures are recited in mutually different dependent claims does not indicate that a combination of these measures cannot be used to advantage.

The invention further applies to a probe or parts thereof comprising one or more of the characterising features described in the description and/or shown in the attached drawings. The invention further pertains to a method or process comprising one or more of the characterising features described in the description and/or shown in the attached drawings.

The various aspects discussed in this patent can be combined in order to provide additional advantages. Furthermore, some of the features can form the basis for one or more divisional applications.

### Brief description of the drawings

Embodiments of the invention will now be described, by way of example only, with reference to the accompanying schematic drawings in which corresponding reference symbols indicate corresponding parts, showing an embodiment of a construction element, and showing in:
Figure 1 an embodiment of the probe in cross section;
Figure 2 a detail of figure 1 in exploded view;

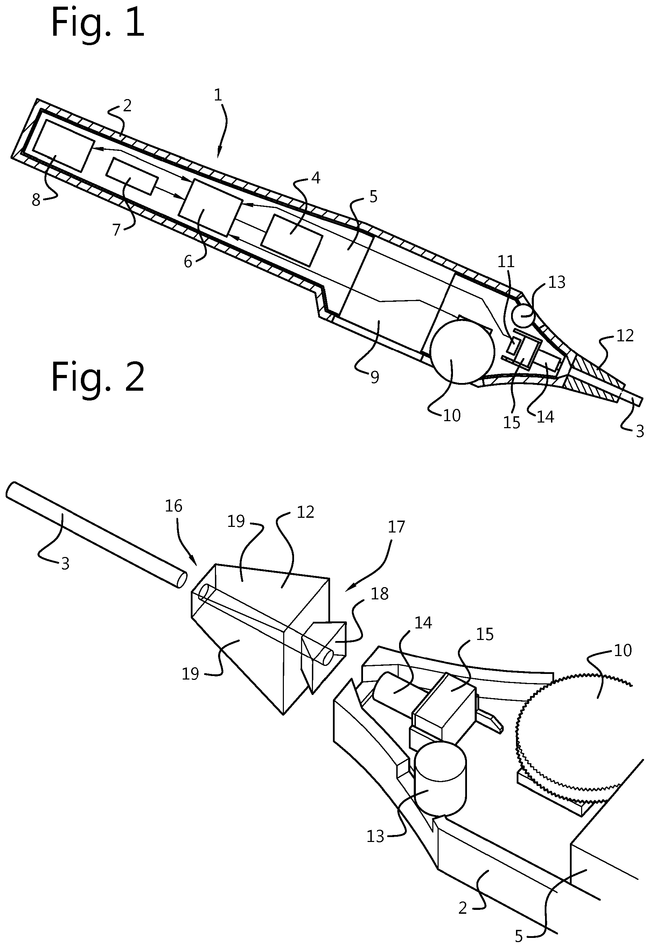

Figure 2 a detail of a part of figure 2;

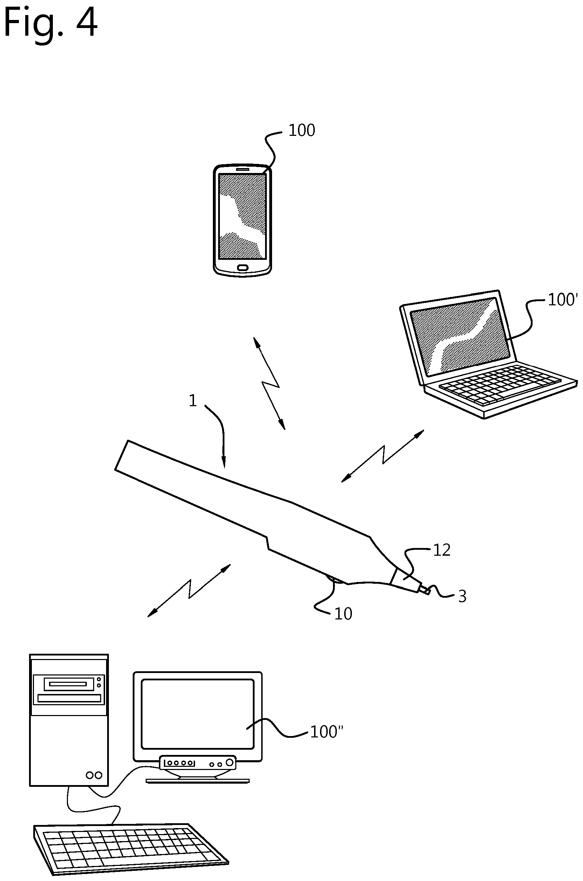

Figure 4 the probe of figure 1 in communication with peripheral devices with a display;

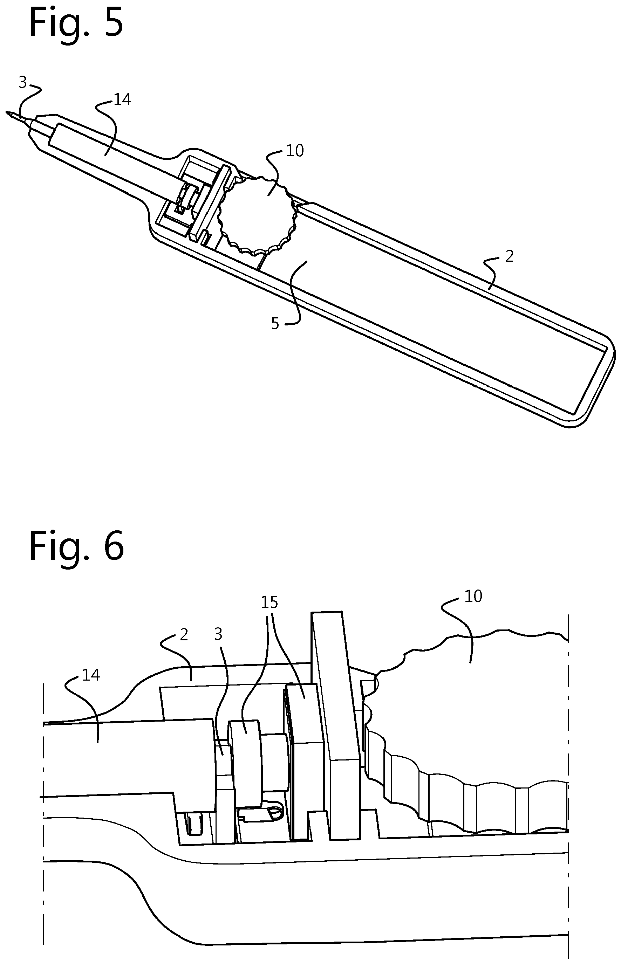

Figure 5 an alternative embodiment of the probe in open view;
Figure 6 a detail of figure 5'

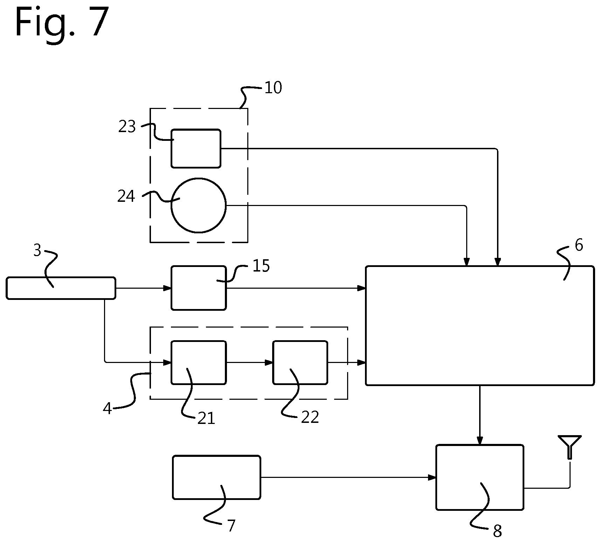

Figure 7 shows a block diagram showing functionalities and components;

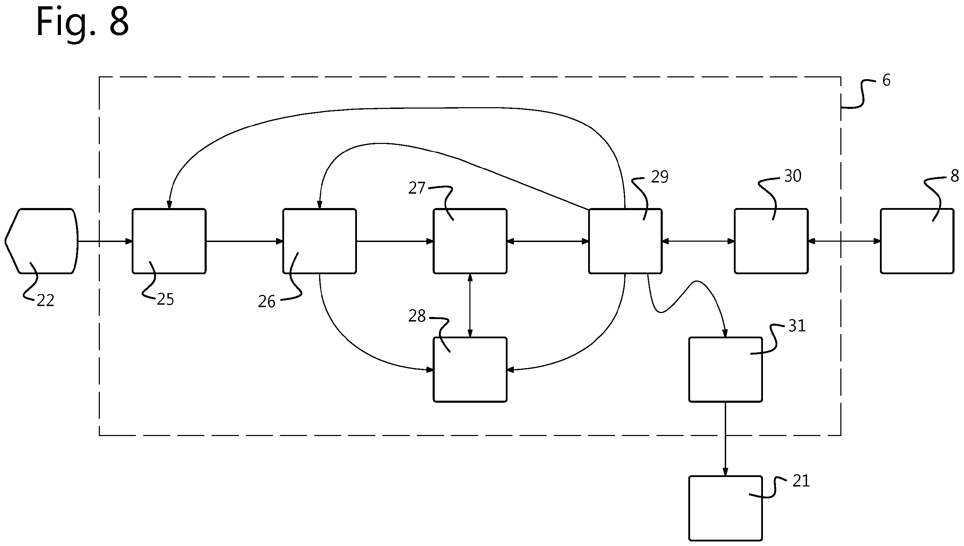

Figure 8 shows a block diagram showing functional blocks in and around the computing device;

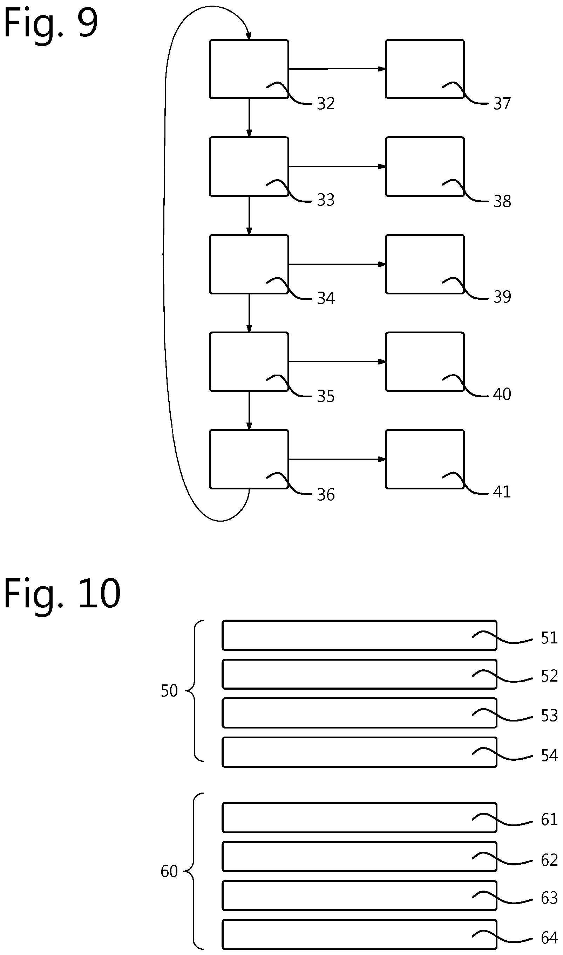

Figure 9 shows a block diagram showing interface examples, and
Figure 10 shows a diagram showing an example of functions on an external device.

The drawings are not necessarily on scale.

### Description of preferred embodiments

Figure 1 shows schematically a cross section of a probe 1. The probe 1 has a housing 2 and a measuring tip 3. The probe 1 is shaped in such a way that it allows a user to easily handle the probe 1, to reach sometimes difficult-to-reach measuring spots on a circuit board of inside an electronics device. In particular, the probe is designed to allow a used to preform measurements with one hand only.

In the current embodiment, the measuring probe is substantially pen-shaped. This allows easy handling in a human hand. Furthermore in the current embodiment, the probe is slim to allow access to sometimes hard-to-reach measuring spots. The probe also can be light in weight. The end opposite to the measuring tip 3 can support wireless communication. Other shapes, however, may be conceivable. Usually, however, a relatively slim measuring end is selected for the above-mentioned reasons. Furthermore, an end that in use extends a little from the human hand will be selected for supporting wireless communication. The housing is usually made from a non-electrically conductive material. Usually, the housing is from a polymer material and may be produced suing injection moulding, 3D printing, or the like.

For instance, when the probe is pen shaped, it can have a length of between 10 and 20 cm, and have a thickness of between 0.5 and 3 cm.

The measuring tip 3 can contact an electrical signal processing circuit 4. The electrical signal processing circuit 4 comprising a data capturing circuit. In the current embodiment, a circuit board 5 is provided inside the housing 2. In the drawing, schematically several functional components are indicated. Lines indicate functional coupling of a component or part that may comprise a device. The circuit board carries the electrical signal processing circuit. The electrical signal processing circuit 4 in the current embodiment comprises an analogue circuit for adapting the impedance, and for instance provide overvoltage protection. The analogue circuit is coupled to an analogue-to-digital converter (ADC). The ADC in turn is coupled to a digital circuit. In the current embodiment, the digital measurement circuit comprises an FPGA, and a memory. In an embodiment, the memory comprises a loop memory or ring buffer. A circular buffer, cyclic buffer or ring buffer is a data structure that uses a single, fixed-size buffer as if it were connected end-to-end. In the buffer, the measurement circuit in an embodiment compares the measurement data against one or more predefined, in particular user defined, trigger conditions. Once a trigger condition is met or while a trigger condition is met, the measurement data can be transmitted to the data communication device 8. In particular, the amount of measurement data or the data size that is transferred to the communication device 8 may be optimized for wireless data transmission.

The probe further comprises a computing device 6 comprising a data processor and memory for data storage. In an embodiment, further removable data storage may be provided, for instance in the form of a memory card and memory card reader.

Probe 1 further comprises a wireless data communication device 8. Usually, the wireless communication device 8 uses electromagnetic radiation like radio frequencies, using for instance known digital data transmission protocols like Bluetooth, WIFI, ZigBee, or the like.

Other means for wireless data communication may also be conceivable, like using electromagnetic radiation in other frequency ranges like light (VIS), UV or IR. This may be used in applications where radio frequencies from a measuring probe 1 may interfere with a device to be measured.

The wireless data communication device 8 in an embodiment may be provided in the probe away from the measuring tip. For instance, the wireless communication device 8 may be provided at an end of the probe opposite to the measuring tip. Or, the wireless communication device may comprise one or more antennas positioned away from the measuring tip, for instance in the probe at an opposite end. Thus, interference may be limited. Furthermore, shielding by means of the user's hand may be limited.

The probe 1 further comprises a motion detection device 7, like for instance an accelerometer or similar motion detection device. The motion detection device is coupled to the power source. As soon as user motion is detected, i.e., when the probe 1 is lifted up by a user, the motion detection device 7 activates the wireless communication device 8 and if required the computing device for making the probe 1 stand-by for measuring and/or data communication.

Probe 1 further comprises a power source 9. A power source may comprise a battery like a rechargeable battery, or a capacitor for swift charging. In an embodiment, the power source 9 may de adapted for remote charging.

For allowing a user to easily control the probe 1, for instance for setting its functionality, a user input device 10 is provided. In this embodiment, the user input device 10 is provided in the form of a "thumb wheel". This allows easy control during measuring. Other implementations of a user input device 10 are also possible. Examples are a touch-sensitive surface and/or a pressure-sensitive, allowing various user motion for controlling the probe 1. Alternatively, a microphone may be included in the probe for voice control. The user input device 10 may also comprise a push-button.

In an embodiment, the user input device 10 and the user feedback device 11 are functionally coupled to the computing device 6. Thus, the computing device can handle part of the user communication that runs via the probe 1.

The measuring tip 3 is in an embodiment is spring-biased away from the measuring circuit 4. The measuring tip 3 can be spring-biased into its released position. In this embodiment, the measuring tip is coupled to a push-button that in one position disconnects the measuring tip 3 from the electrical signal processing circuit 4. In this way, the measuring tip 3 can displace from a released position in which is not in contact with the measuring circuit, to a measuring position in which measuring tip 3 is in functional contact with the electrical signal processing circuit 4. In this measuring position, a signal or voltage from a measuring point in a device or a circuit are transferred via the (conductive) measuring tip 3 to the electrical signal processing circuit 4. Alternatively, a functional coupling, usually electrically conductive contact, can be provided via the user control mentioned earlier. The biased tip, allowing the tip to be pushed in its axial direction, provides a simple interface for allowing a user to start and stop measurements. In an embodiment, the measuring tip is in constant connection with the electrical signal processing circuit 4. When the probe is pressed down by a user with the measuring tip 3 onto the measuring point with a predefined pressure, the measuring tip 3 goes from its released position into its capturing position. The measuring tip 3 in this position here activates a switch. This can provide a signal that starts transmission of measurement data via the communication device 8. In an embodiment, the wireless transmission device 8 transmits measurement data as long as the measurement tip 3 is in its capturing position. When released, the measurement tip returns to its released position.

The probe 1 further comprises a user feedback device 11. The user feedback device 11 can provide a feedback to a user that is perceivable via at least one of the senses of that user. An example of such a feedback is providing at least one selected from visual, audible and sensory feedback. Thus, for instance a vibrator may be incorporated into the probe 1 for providing sensory feedback. For instance, a slight continuous vibration may indicate that a voltage is detected or being measured. A pulsed vibration may indicate that measurement data is being transmitted.

In yet another embodiment of the user feedback device 11, a speaker is included for providing audible feedback. Again, a continuous, buzzing tone may for instance indicate that the measurement tip is in contact with a measurement point that is at a certain voltage. The volume may indicate a relative voltage level. An intermittent buzz may indicate transmission of measurement data.

In yet another embodiment of the user feedback device 11, the user feedback device 11 provides visual feedback. In an embodiment, the probe 1, in particular the user feedback device, comprises a light device, for instance comprising a multicoloured LED. The computing device may provide user feedback via the user feedback device, indicating for instance to a user the status of the probe, if data has been captured, or if there is a failure. Using for instance the colour of the light, or a blinking sequence, user feedback can be provided via the user feedback device 11.

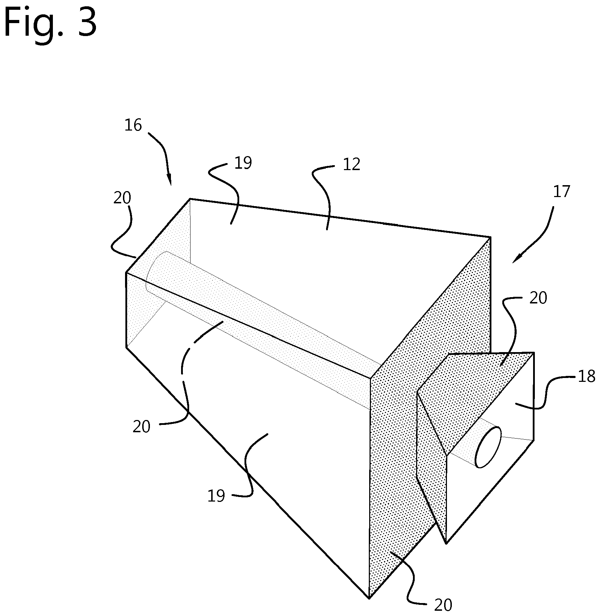

In the current embodiment of figures 1 and 2, the user feedback device 11 further comprises a diffusor end 12 for providing light of a light source to be visible near the measuring tip 3. The diffusor end 12 is further shown in figure 2 and in yet more detail in figure 3. The diffusor end 12 has a measuring tip end 16 and a housing end 17. In this embodiment, the measuring tip 3 runs through the diffusor end 3. The diffusor end comprises a surface for coupling light in 18, and light-diffusing surfaces for diffusing light out of the probe 1 and out of the diffusor end 12. In that way, the light form the light device can be seen or observed by the user at or near the measuring tip 3. In an embodiment, the diffusor end 12 is designed in such a way that the light does not shine on the measuring spot or measuring point. To that end, some surfaces or part of surfaces 20 of the diffusor end 12 are internally reflective. For instance, such reflective surfaces 20 that are directed with a normal in the direction of the measuring tip 3 are internally reflective. In that way, light travelling in the direction of the measuring tip 3 is reflected back into the diffusor end 12. In the current embodiment, the user feedback device comprises a light pipe for conducting light from the further housing of the probe to the diffusor end 12. Other surfaces are defined as diffusor emission surfaces 20. These surfaces for instance are roughed in order to diffuse light out of the diffusor end 12 in a diffuse way. In that way, a user can see it when using the probe, independent of the position with respect to the probe.

In order to couple light into the diffusor end 12, the diffusor end 12 has a surface 18 that is adapted for coupling light in into the diffusor end 12.

In the current embodiment of figures 1-3, the diffusor end 12 has an extending part that comprises a restriction. The extending part can be mounted inside the housing 2 in order to attach it to the probe 1 and make it part of the probe 1. The diffusor end 12 has a hole extending through the diffusor end 12, for passing the measuring tip 3.

In the embodiment of figures 5 and 6, one or more LED's or other light emitting devices may be incorporated in the end of the probe 1 opposite to the measuring tip end. In that way, light does not interfere with the measuring point, while a user can easily see it.

In yet another embodiment, a display, even a touch-sensitive display, may be incorporated into the housing of the probe. In that way, user feedback and even user input may be allowed. Thus, a combiner user input device 10 and user feedback device 11 can be provided.

In figure 4, the probe 1 is shown in interaction with one or more peripheral devices 100-100". In particular, the probe 1 in cooperation with one or more of these peripheral devices functionally provide a "traditional" oscilloscope. The peripheral devices 100-100" have a display for showing the user a representation of measured data. Furthermore, the display can show a graphical user interface for representing settings of the probe 1, and for allowing the user to modify settings in the probe 1. The peripheral device may be a mobile device with a display, like a smartphone, tablet, laptop, or the like. More than one peripheral devices may be coupled at one time. The peripheral device may also comprise a device that is coupled via a network. Thus, for instance the probe 1 couples via the network to the peripheral device.

In an embodiment, the user input via the user input device 10 of the probe 1 is transmitted via the wireless communication device 8 to a peripheral device 100-100". The peripheral device shows a representation of the user input on its display. For instance, a user turns a thumb wheel of the probe 1. Each change is transmitted to the peripheral device. There, a for instance a scroll-down menu is shown, and each change in position of the thumb wheel is shown on the display of the peripheral device by going down the scroll-down menu. When pushing a button, the selection in the scroll-down menu is activated. For instance, a threshold is changed. The peripheral device sends the change to the probe 1 as a new or updated setting.

The peripheral device can also show a representation of measurement data, for instance showing a graphical representation of the measurement data. This representation can be an (almost) life representation of measurement data. For instance, a time delay of several milliseconds or less may be possible. Thus, while the probe 1 is pressed with its measurement tip onto the measuring point, and the measurement tip 3 is in its capturing position, data packages of measurement data are sent to the peripheral device. This transmission may be (almost) life, or a short time delay of several millisecond at the most may be possible.

At the peripheral device, for instance a graph is displayed, showing for instance a time-based voltage.

On the peripheral device, software may be running that allows a user to define trigger events. Thus, one or more user-defined triggers may be defined. The software, running on a peripheral device, for instance transforms this user-defined trigger into a trigger that can be implemented in the probe. The software running on the peripheral device sends the user defined trigger or triggers to the probe 1 via its wireless communication device 8. At the probe 1, the trigger or triggers are for instance implemented in the FPGA. This digital circuit that is part of the electrical signal processing circuit allows fast data processing, as explained above. Using for instance a ring buffer, the measurement data that is first digitized using an analogue-to-digital converter (ADC) can be compared with the user-defined trigger or triggers. This may generate trigger events, for instance starting data transmission from the wireless data transmitter to the peripheral device.

In an embodiment, when an event is generated to transmit digital measurement data, data packages that match optimized data package size for the wireless transmission selected are created from a ring buffer content. Thus, relatively large amounts of measurement data can be transmitted swiftly.

In figures 7-10, several block diagrams are depicted that explain and provide examples of some functionality, components and interface.

Figure 7 shows an example of functional coupling of components and functionalities in the probe 1. Measuring tip 3 provides an electrical contact to the electrical signal processing circuit 4 and a mechanical coupling providing a capturing position and a released position via a pressure contact like a micro switch 15. The micro switch is coupled to the computing device 6. When in this embodiment the measuring tip is brought to the capturing position, it triggers the computing device 6 to start processing measurement samples.

In the embodiment of figure 7, the electrical signal processing circuit 4 comprises analogue circuitry 21 that is coupled to an analogue -to-digital converter or ADC 22. The electrical signal processing circuit 4 is coupled to the computing device 6. In this embodiment, the computing device is coupled to the wireless data communication device 8, for instance a WIFI-module. In this embodiment, the wireless communication device is directly coupled to a motion detection device 7, for instance an accelerometer. If motion is detected, it activates the wireless data communication device for instance already connecting to an external device to be ready for transmitting measurement data.

In this embodiment, the user input device 10 is coupled to the computing device 6, and here comprises a thumb wheel 24 and a push button 23. The computing device in this embodiment comprises memory for storing measurement data and may comprise an FPGA.

Figure 8 shows an embodiment of a computing device 6 with some attached functional parts, like the ADC 22, the wireless data communication device 8 and the analogue circuitry 21.

The computing device 6 in this embodiment comprises several functional blocks or modules 25-31. In this embodiment, the computing device provides clock signals to the ADC 22. The ADC may for instance transfer 8 bit digital numbers to a packet builder 25. The packet builder adds for instance 4 digital measurement numbers from the DAC 22 into one 32 bits packet. Here, the sample builder 25 runs at a higher clock speed than the rest of the computing device, here two times the clock speed of the further computing device, here for instance 200 MHz.

The computing device 6 here comprises a sampler 26

The computing device 6 here comprises a wireless communication interface 29. This stage makes measurement data ready for wireless transmission. It combines measurements in order to optimize for transmission. For instance, the data may be put in packages making for instance WIFI transmission optimal. The wireless communication interface 29 also processes incoming wireless communication, for instance relating to change of various settings, like modification of triggers in trigger engine 28, modification of sampling in the sampler 26, modification of the package builder 25 settings, modification of the analogue circuitry 21, via the analogue stage configurator 31.

The computing device 6 here comprises a sample accumulator (storage) 27. This can be a revolving memory or revolving buffer, as indicated earlier. The sampler 26 adds measurement data to the sample accumulator 27, and in this embodiment the trigger engine 28 compares the measurement data with defined trigger settings. In case the measurement data matches the trigger settings, measurement data is transferred to the wireless data communication interface 29. From there, measurement data is transferred to the wireless module interface 30 and from there transferred to the wireless data transmission device 8 for transmitting external of the probe 1.

Figure 9 shows an example of a user interface that can be activated and controlled via the user input device. Usually, this user interface runs on an external/peripheral device 100 and is displayed on a display of that external device 100. In this example, for instance a thumb wheel and push button on the probe 1 may be used. When clicking on that push button, the menu may change in a revolving way from
32 X-axis (time) zoom to
33 X-axis time offset to
34 Y-axis (volts) zoom to
35 Y-axis (volts) offset to
36 trigger level offset, and back to
32 X-axis (time) zoom.

When activating the thumb wheel on one of the items 32-36, the following actions may take place (changing the graph of the signal on the external device for instance (almost) live:
37 change time base (zoom in/out),
38 change time offset,
39 change vertical zoom,
40 change vertical offset,
41 change trigger level.

Figure 10 shows an example of functions that may only be available on the external/peripheral device 100 using software running on that external/peripheral device 100. The functions may relate to a trigger 50 or for instance to analysis 60.

The trigger 50 settings may comprise selecting an action from:
51 Launching an "auto-set" sequence
52 Trigger polarity configuration (Rising / falling)
53 Trigger position (on horizontal axis)
54 Trigger mode (Single shot, Auto, Normal, scrolling)

The analysis 60 settings may for instance comprise selecting an action from:
61 Taking a screenshot
62 Applying math functions, like for instance Fast Fourrier Transform (FFT) analysis
63 Applying automatic measurements
64 Adding cursors for measurement.

The probe 1 thus provides a versatile measuring device that is easy to use, even in difficult places or measuring spots in an apparatus. Furthermore, the probe 1 can remain relatively simple. The data communication device 8 allows almost real time data transfer from the probe 1 to an external device 100, allowing display. Furthermore, the user input device actions can be transferred (almost) instantaneously to the external (peripheral) device 100, allowing the experience of direct control to a user. Trigger settings may for instance be set, showing a graphical user interface on the external/peripheral device 100. This again provides a user an experience as if the probe 1 and the peripheral device are directly connected. Further provisions like the motion detection and the measuring tip having a capturing position and a released position reduce power consumption, extending the disconnected use time of the probe 1.

It will also be clear that the above description and drawings are included to illustrate some embodiments of the invention, and not to limit the scope of protection. Starting from this disclosure, many more embodiments will be evident to a skilled person.

### Reference numbers

- 1: probe
- 2: housing
- 3: measuring tip
- 4: electrical signal processing circuit
- 5: circuit board
- 6: computing device
- 7: motion detection device
- 8: wireless data communication device
- 9: power source
- 10: user input device
- 11: user feedback device
- 12: diffusor end
- 13: grounding
- 14: grounding pipe
- 15: micro switch
- 16: diffusor measuring tip end
- 17: diffusor housing end
- 18: diffusor end surface for coupling light in
- 19: diffusor emission surface
- 20: diffusor (internal) reflective surface
- 21: analogue circuitry
- 22: Analogue to digital converter (ADC)
- 23: push button
- 24: thumb wheel
- 25: packet builder
- 26: sampler
- 27: sample accumulator (storage)
- 28: trigger engine
- 29: wireless communications interface
- 30: wireless communication module interface
- 31: Analogue stage configurator
- 32: X-axis (time) zoom
- 33: X-axis time offset
- 34: Y-axis (volts) offset
- 35: trigger level offset
- 36: change time base (zoom in/out)
- 37: change time offset
- 38: change vertical zoom
- 39: change vertical offset
- 40: change trigger level
- 50: trigger
- 51: Launching an "auto-set" sequence
- 52: Trigger polarity configuration (Rising / falling)
- 53: Trigger position (on horizontal axis)
- 54: Trigger mode (Single shot, Auto, Normal, scrolling)
- 60: Analysis
- 61: Taking a screenshot
- 62: Applying math functions like FFT analysis
- 63: Applying automatic measurements
- 64: Adding cursors for measurement
- 100, 100', 100": Peripheral devices

## Claims

1. A probe (1) for measuring a waveform of a time-based electrical signal at a measuring point in a circuit, said probe (1) comprising a housing (2) provided at one end with a measuring tip (3), wherein said housing (2) is further provided with a power supply (9), an electrical signal processing circuit (4), a data processor, and a wireless communication device (8), said electrical signal processing circuit (4), and said wireless communication device (8) functionally coupled to said data processor, wherein said electrical signal processing circuit comprises an analogue circuit for adapting the impedance , a subsequent analogue-to-digital converter, a subsequent digital signal measurement circuit, and a memory, **characterised in that** said housing is further provided with a user input device (10) functionally coupled to said data processor, wherein said measuring tip (3) comprises a capturing position in which capturing measurement data is provided while said measuring tip (3) is in said capturing position, and a released position, wherein said measuring tip (3) is biased in said released position and adapted to be manually pressed into said capturing position, and when subsequently released to its released position stops capturing measurement data, and wherein said digital signal measurement circuit being configured for comparing said measurement data against one or more predefined trigger conditions, and when said one or more trigger conditions are met transmitting said measurement data to the communication device (8).

2. The probe (1) of claim 1, wherein in said capturing position said measuring tip (3) provides an event for capturing and transmitting measurement data.

3. The probe (1) of any one of the preceding claims, wherein when said measuring tip (3) is in its capturing position, captured measurement data is stored into a memory and transmitted via said wireless communication device (8).

4. The probe (1) of any one of the preceding claims, wherein said wireless communication device (8) is coupled to said data processor for transmitting measurement data to an external device comprising a display.

5. The probe (1) of any one of the preceding claims, wherein said user input device (10) is functionally coupled to said data processor for providing a user input to said data processor.

6. The probe (1) of any one of the preceding claims, further comprising a user feedback device (11), functionally coupled to said data processor, for providing user feedback selected from measurement data, probe status, and probe setting information.

7. The probe (1) of the previous claim, wherein said user feedback device (11) comprises a lighting element in said housing, for providing visual feedback on an operational mode or measurement data.

8. The probe (1) of any one of the preceding claims, further comprising a motion detection device (7) in said probe (1) that is operationally coupled to said data processor, in particular said motion detection device (7) is adapted for setting said data processor in a mode that sets the data processor ready for receiving measurement data and for controlling said wireless communication device (8) for transmitting said received measurement data when motion is detected, in particular furthermore said measurement tip (3) is coupled to said data processor for in its capturing position activating said data processor in an active mode for receiving measurement data and controlling said wireless communication device (8) for transmitting said received measurement data while said measuring tip (3) is in its capturing position.

9. The probe (1) according to any one of the preceding claims, wherein said measurement tip (3) has an elongated shape, in particular rod-shaped, and is biased in its longitudinal direction, wherein said measurement tip (3) is coupled to a switch (15) that is functionally coupled to at least one selected from said wireless communication device (8), said electrical signal processing circuit (4), and said data processor.

10. The probe (1) according to any one of the preceding claims, wherein said probe (1) further comprises a grounding attachment (13) for attaching a grounding wire.

11. An oscilloscope system comprising the probe (1) of any one of the preceding claims and an external computer device (100), including at least one selected from a smartphone, tablet, a notebook, said external computer device comprising a display, a wireless communication device for communicating with said wireless communication device of said probe, and a data processor, functionally coupled with said display and said wireless communication device of the computer device.

12. The oscilloscope system of claim 11, wherein said computer device comprises software which, when running on said computer device, allows said computer device to receive data from said probe and to display a representation of said data on said display, in particular allows said computer device to receive user input via said user input device, display said user input on said display, and transmit data to said probe based upon said user input.

13. A method for measuring an electrical signal using an oscilloscope system according to claim 11 or 12, wherein said measurement tip is contacted with said measurement point, said housing is pressed down in a longitudinal direction of said measurement tip from said released position into said capturing position, electrical signal data is captured as measurement data, and said measurement data is transmitted to said computer device and displayed on said display.

14. The method of claim 13, wherein said measurement data is transmitted while said measurement tip is in said capturing position.

15. The method of claims 13 or 14, wherein user input on the user input device is transmitted via said wireless communication device to said computer device and a representation of said user input is displayed on said display of said computer device, and data is transmitted from said computer device to said wireless communication device for amending probe settings.

## Patentansprüche

1. Sonde (1) zum Messen einer Wellenform eines zeitbasierten elektrischen Signals an einem Messpunkt in einer Schaltung, wobei die Sonde (1) ein Gehäuse (2) umfasst, das an einem Ende mit einer Messspitze (3) versehen ist, Gekennzeichnet in dass das Gehäuse (2) ferner mit einer Stromversorgung (9), einer elektrischen Signalverarbeitungsschaltung (4), einem Datenprozessor, einem drahtlosen Kommunicationsvorrichtung (8), und eine Benutzereingabevorrichtung (10) versehen ist, wobei die elektrische Signalverarbeitungsschaltung (4), die drahtlose Kommunikationsvorrichtung (8) und die Benutzereingabevorrichtung (10) funktionell mit dem Datenprozessor gekoppelt sind, und wobei die Messspitze (3) eine Erfassungsposition umfasst, in der Erfassungsmessdaten bereitgestellt werden, und eine freigegebene Position wobei die Messspitze (3) in der freigegebenen Position vorgespannt und angepasst ist um manuell in die Erfassungsposition gedrückt zu werden, und wobei wenn sie anschließend in ihre freigegebene Position freigegeben werden, keine Messdaten mehr erfasst werden, und wobei die elektrische Signalverarbeitungsschaltung (4) eine Analogschaltung zum Anpassen der Impedanz, eine nachfolgende Analog-Digital-Wandler, eine nachfolgende digitale Signalmessschaltung und einen Speicher umfasst, die digitale Signalmessschaltung zum Vergleichen der Messdaten mit einer oder mehreren vordefinierten Triggerbedingungen und wenn die eine oder mehreren Triggerbedingungen erfüllt sind, werden die Messdaten an die Kommunikationsvorrichtung (8) übertragen.

2. Sonde (1) nach Anspruch 1, wobei in der Erfassungsposition die Messspitze (3) ein Ereignis zum Erfassen und Übertragen von Messdaten bereitstellt.

3. Sonde (1) nach einem der vorhergehenden Ansprüche, wobei, wenn sich die Messspitze (3) in ihrer Erfassungsposition befindet, erfasste Messdaten in einem Speicher gespeichert und über die drahtlose Kommunikationsvorrichtung (8) übertragen werden.

4. Sonde (1) nach einem der vorhergehenden Ansprüche, wobei die drahtlose Kommunikationsvorrichtung (8) mit dem Datenprozessor gekoppelt ist, um Messdaten an eine externe Vorrichtung zu übertragen, die eine Anzeige umfasst.

5. Sonde (1) nach einem der vorhergehenden Ansprüche, wobei die Benutzereingabevorrichtung (10) funktional mit dem Datenprozessor gekoppelt ist, um eine Benutzereingabe an den Datenprozessor bereitzustellen.

6. Sonde (1) nach einem der vorhergehenden Ansprüche, ferner umfassend eine Benutzer-Rückkopplungsvorrichtung (11), die funktionell mit dem Datenprozessor gekoppelt ist, um eine Benutzer-Rückmeldung bereitzustellen, die aus Messdaten, Sondenstatus und Sondeeinstellungsinformationen ausgewählt ist.

7. Sonde (1) nach dem vorherigen Anspruch, wobei die Benutzer-Rückkopplungsvorrichtung (11) ein Beleuchtungselement in dem Gehäuse (2) umfasst, um eine visuelle Rückmeldung über einen Betriebsmodus oder Messdaten bereitzustellen.

8. Die Sonde (1) nach einem der vorhergehenden Ansprüche, ferner umfassend eine Bewegungserfassungsvorrichtung (7) in der Sonde (1), die betriebsmäßig mit dem Datenprozessor gekoppelt ist, insbesondere die Bewegungserfassungsvorrichtung (7), ist angepasst, um den Datenprozessor in einen Modus zu versetzen, der den Datenprozessor bereit macht zum Empfangen von Messdaten und zum Steuern der drahtlosen Übertragung zum Senden der empfangenen Messdaten, wenn eine Bewegung erfasst wird, insbesondere ist ferner die Messspitze (3) mit dem Datenprozessor gekoppelt, um in seiner Erfassungsposition den Datenprozessor in einem aktiven Modus zum Empfangen von Messdaten zu aktivieren und Steuern der drahtlos gesendeten zum Senden der empfangenen Messdaten, während sich die Messspitze (3) in ihrer Erfassungsposition befindet

9. Sonde (1) nach einem der vorhergehenden Ansprüche, wobei die Messspitze (3) eine längliche Form aufweist, insbesondere stabförmig, und in ihrer Längsrichtung vorgespannt ist, wobei die Messspitze (3) mit einem Schalter (15) gekoppelt ist, der funktionell mit mindestens gekoppelt ist eine ausgewählt aus der Kommunikationsvorrichtung (8), der elektrischen Signalverarbeitungsschaltung (4) und dem Datenprozessor.

10. Sonde (1) nach einem der vorhergehenden Ansprüche, wobei die Sonde (1) ferner einen Erdungsaufsatz (13) zum Anbringen eines Erdungsdrahtes umfasst.

11. Oszilloskopsystem, umfassend die Sonde (1) nach einem der vorhergehenden Ansprüche und ein externes Computergerät (100), einschließlich mindestens eines, ausgewählt aus einem Smartphone, Tablet, einem Notebook, wobei das externe Computergerät ein Display umfasst, ein drahtloses Kommunikationsgerät zum Kommunizieren mit dem drahtlosen Kommunikationsvorrichtung (8) der Sonde (1) und ein Datenprozessor, der funktionell mit der Anzeige und der drahtlosen Kommunikationsvorrichtung (8) der Computervorrichtung gekoppelt ist.

12. Oszilloskop nach Anspruch 11, wobei die Computervorrichtung Software umfasst, die es dem Computergerät ermöglicht, Daten von der Sonde (1) zu empfangen und eine Darstellung der Daten auf der Anzeige anzuzeigen, insbesondere dem Computergerät, dies zu ermöglichen Empfangen von Benutzereingaben über das Benutzereingabegerät, Anzeigen der Benutzereingaben auf dem Display und Senden von Daten an die Sonde (1) basierend auf den Benutzereingaben.

13. Verfahren zum Messen eines elektrischen Signals unter Verwendung eines Oszilloskopsystems nach einem der vorhergehenden Ansprüche, wobei die Messspitze (3) mit dem Messpunkt in Kontakt gebracht wird, wobei das Gehäuse (2) in Längsrichtung der Messspitze (3) von der freigegebenen Position in die nach unten gedrückt wird, elektrische Signaldaten als Messdaten erfasst werden, und die Messdaten an das Computergerät übertragen und auf dem Display angezeigt werden.

14. Verfahren nach Anspruch 13, wobei die Messdaten übertragen werden, während sich die Messspitze (3) in der Erfassungsposition befindet.

15. Verfahren nach Anspruch 13 oder 14, wobei Benutzereingaben an der Benutzereingabevorrichtung über die drahtlose Kommunikationsvorrichtung (8) an die Computervorrichtung übertragen werden und eine Darstellung der Benutzereingaben auf der Anzeige der Computervorrichtung angezeigt wird und Daten von dieser übertragen werden Computergerät an das drahtlose Kommunikationsgerät zum Ändern der Sondeneinstellungen.

## Revendications

1. Une sonde (1) pour mesurer une forme d'onde un signal électrique en base de temps en un position de mesure dans un circuit, ladite sonde (1) comprenant un boîtier (2) pourvu à une extrémité d'une pointe de mesure (3), **caractérisé en ce que** ledit boîtier (2) étant en outre pourvu d'une alimentation électrique (9), d'un circuit de traitement de signal électrique (4), d'un processeur de données, d'un dispositif de communication sans fil (8) et d'un dispositif d'entrée utilisateur (10), ledit circuit de traitement de signal électrique (4), ledit dispositif de communication sans fil (8) et ledit dispositif d'entrée utilisateur (10) fonctionnellement couplés audit processeur de données, et ladite pointe de mesure (3) comprend une position de capture dans laquelle la capture de données de mesure est fournie pendent ladite pointe de mesure est dans sa position de capture, et une position libérée dans laquelle ladite pointe de mesure (3) sollicitée dans ladite position libérée et adaptée pour être pressée manuellement dans ladite position de capture, et lorsqu'elle est ensuite relâchée dans sa position libérée arrête de capturer des données de mesure, et dans lequel ledit circuit de traitement de signal électrique (4) comprend un circuit analogique pour adapter l'impédance, un convertisseur analogique-numérique ultérieur, un circuit de mesure de signal numérique ultérieur et une mémoire , ledit circuit de mesure de signal numérique pour comparer lesdites données de mesure à une ou plusieurs conditions de déclenchement prédéfinies, et lorsque lesdites une ou plusieurs conditions de déclenchement sont satisfaites, transmettre lesdites données de mesure au dispositif de communication sans fil (8).

2. La sonde (1) de la revendication 1, dans laquelle, dans ladite position de capture, ladite pointe de mesure (3) fournit un événement pour capturer et transmettre des données de mesure.

3. La sonde (1) selon l'une quelconque des revendications précédentes, dans laquelle, lorsque ladite pointe de mesure (3) est dans sa position de capture, les données de mesure capturées sont stockées dans une mémoire et transmises via ledit dispositif de communication sans fil (8).

4. La sonde (1) selon l'une quelconque des revendications précédentes, dans laquelle ledit dispositif de communication sans fil (8) est couplé audit processeur de données pour transmettre des données de mesure à un dispositif externe comprenant un affichage.

5. La sonde (1) selon l'une quelconque des revendications précédentes, dans laquelle ledit dispositif d'entrée utilisateur (10) est couplé fonctionnellement audit processeur de données pour fournir une entrée utilisateur audit processeur de données.

6. La sonde (1) selon l'une quelconque des revendications précédentes, comprenant en outre un dispositif de rétroaction utilisateur (11), couplé fonctionnellement audit processeur de données, pour fournir un retour utilisateur sélectionné parmi les données de mesure, l'état de la sonde et les informations de réglage de la sonde.

7. La sonde (1) selon la revendication précédente, dans laquelle ledit dispositif de rétroaction utilisateur (11) comprend un élément d'éclairage dans ledit boîtier, pour fournir une rétroaction visuelle sur un mode opérationnel ou des données de mesure.

8. La sonde (1) selon l'une quelconque des revendications précédentes, comprenant en outre un dispositif de détection de mouvement (7) dans ladite sonde (1) qui est couplé opérationnellement audit processeur de données, en particulier ledit dispositif de détection de mouvement (7) est adapté pour régler ledit processeur de données dans un mode qui met le processeur de données prêt pour recevoir des données de mesure et pour commander ladite dispositif de transmission sans fil (8) pour transmettre lesdites données de mesure reçues lorsqu'un mouvement est détecté, en particulier en outre, ladite pointe de mesure (3) est couplée audit processeur de données, dans sa position de capture, pour activer ledit processeur de données dans un mode actif pour recevoir des données de mesure et commander ladite dispositif de transmission sans fil (8) pour transmettre lesdites données de mesure reçues pendant que ladite pointe de mesure (3) est dans sa position de capture.

9. La sonde (1) selon l'une quelconque des revendications précédentes, dans laquelle ladite pointe de mesure (3) a une forme allongée, en particulier en forme de tige, et est sollicitée dans sa direction longitudinale, dans laquelle ladite pointe de mesure (3) est couplée à un commutateur (15) qui est fonctionnellement couplé à au moins un sélectionné parmi ledit dispositif de communication sans fil (8), ledit circuit de traitement de signal électrique (4), et ledit processeur de données.

10. La sonde (1) selon l'une quelconque des revendications précédentes, dans laquelle ladite sonde (1) comprend en outre une fixation de mise à la terre (13) pour attacher un fil de mise à la terre.

11. Un système oscilloscope comprenant la sonde (1) selon l'une quelconque des revendications précédentes et un dispositif informatique externe, comprenant au moins un sélectionné parmi un smartphone, une tablette, un ordinateur portable (100), ledit dispositif informatique externe comprenant un affichage, un dispositif de communication sans fil pour communiquer avec ledit sans fil. un dispositif de communication de ladite sonde et un processeur de données, couplé fonctionnellement audit affichage et audit dispositif de communication sans fil du dispositif informatique.

12. L'oscilloscope selon la revendication 11, dans lequel ledit dispositif informatique comprend un logiciel qui, lorsqu'il s'exécute sur ledit dispositif informatique, permet audit dispositif informatique de recevoir des données de ladite sonde et d'afficher une représentation desdites données sur ledit affichage, en particulier permet audit dispositif informatique de recevoir une entrée utilisateur via ledit dispositif d'entrée utilisateur, d'afficher ladite entrée utilisateur sur ledit affichage, et de transmettre des données à ladite sonde sur la base de ladite entrée utilisateur.

13. Un procédé de mesure d'un signal électrique utilisant un système d'oscilloscope selon les revendications 11 ou 12, dans lequel ladite pointe de mesure (3) est en contact avec ledit position de mesure, ledit boîtier est pressé vers le bas dans une direction longitudinale de ladite pointe de mesure depuis ladite position relâchée dans ladite position de capture, les données de signal électrique sont capturées en tant que données de mesure, et lesdites données de mesure sont transmises audit dispositif informatique et affichées sur ledit affichage.

14. Le procédé selon la revendication 13, dans lequel lesdites données de mesure sont transmises pendant que ladite pointe de mesure est dans ladite position de capture.

15. Le procédé selon les revendications 13 ou 14, dans lequel l'entrée utilisateur sur le dispositif d'entrée utilisateur est transmise via ledit dispositif de communication sans fil audit dispositif informatique et une représentation de ladite entrée utilisateur est affichée sur ledit affichage dudit dispositif informatique, et des données sont transmises depuis ledit dispositif informatique vers ledit dispositif de communication sans fil pour modifier les paramètres de sonde.
